# EUROPEAN PATENT APPLICATION

(11) **EP 1 598 854 A1**
(43) Date of publication of application: **23.11.2005**
(21) Application number: 03815973.7
(22) Date of filing: 17.09.2003
(51) Int. Cl.: H01L 21/02, H01L 21/027, G06F 17/60

(54) **SEMICONDUCTOR DEVICE AND SEMICONDUCTOR PRODUCTION MANAGEMENT SYSTEM**

(30) Priority: 20.02.2003 JP 2003042797
(71) Applicant: Hitachi High-Technologies Corporation, Tokyo 105-8717 (JP)
(72) Inventor: NAYA, Hidemitsu, c/o Hitachi Research Laboratory, Hitachi-shi, IBaraki 319-1292 (JP); HASHIMOTO, Koji, c/o Hitachi Research Laboratory, Hitachi-shi, IBaraki 319-1292 (JP); TOMIYOSHI, Rikio, c/o Design & Manufacturing Group, Hitachinaka-shi, Ibaraki 312-8504 (JP); KAWANO, Masamichi, Design & Manufacturing Group, Hitachinaka-shi, Ibaraki 312-8504 (JP)
(74) Representative: Strehl Schübel-Hopf & Partner
(86) International application number: PCT/JP2003/011833
(87) International publication number: WO 2004/075267

(57) **Abstract**

The present invention provides a semiconductor device furnished with tamper-resistant identification information by forming a circuit pattern 2B which differs from one semiconductor chip to another in a semiconductor chip 2 packaged in a semiconductor device 1 in addition to an original circuit pattern 2A and expressing the identification information by this circuit pattern 2B and the invention further provides a semiconductor manufacturing management system targeted at a product mounted with this semiconductor device, capable of managing the product from the manufacturing to the mode of use of the semiconductor device.

## Description

### Technical Field

The present invention relates to a technique for identifying a semiconductor device, and more particularly, to a semiconductor device necessary for the technique and a system for manufacturing and managing such a semiconductor device.

### Background Art

Semiconductor devices such as ICs are generally manufactured in volume according to the same specifications, and therefore product identifiability or so-called traceability including a design process, manufacturing process and even a usage process by users is an important factor in maintaining reliability of the products. For this reason, each semiconductor device is conventionally assigned identification information.

At this time, according to a conventional technology, a storage element such as a flash memory and fuse group are mounted in a semiconductor chip (element) and after the semiconductor chip is manufactured, predetermined information is stored in the storage element and used as identification information or some members of the fuse group are subjected to processing such as cutting and used as identification information.

On the other hand, most products with a built-in semiconductor device are assigned serial numbers so that the products can be easily identified. At this time, the products may also be assigned information to identify their users. In this case, it is a common practice that other information on the users is also stored together.

Here, as such user information, in the case where the product is, for example, a terminal such as a cellular phone, the telephone number, IP address, account name and password, which belong to the user, are used (see JP Patent Publication (Kokai) No. 2001-282653A, JP Patent Publication (Kokai) No. 2002-7253A).

Furthermore, in the case of a product mounted with a semiconductor device, a method of designing the semiconductor based on the specification required by the user of the product is conventionally adopted, and in such a case, the conventional technology collects the user's requests for the semiconductor device, creates specifications of the semiconductor device from the collected information in a greatest-common-denominator-like manner or creates specifications of the semiconductor device in a least-common-multiple-like manner (see JP Patent Publication (Kokai) No. 2002-108946A).

On the other hand, the conventional technology also generally uses a method of creating specifications from requests of an unspecified majority of users in a greatest-common-denominator-like manner or in a least-common-multiple-like manner (see JP Patent Publication (Kokai) No. 2000-67109A, JP Patent Publication (Kokai) No. 2001-60194A, JP Patent Publication (Kokai) No. 2002-92294A, JP Patent Publication (Kokai) No. 11-25161A (1999), JP Patent Publication (Kokai) No. 2001-273393A, JP Patent Publication (Kokai) No. 2001-306783A), and in this case, once the specifications are determined, the designer of the semiconductor inputs the specifications related to the manufacturing of the semiconductor and designs a circuit to be mounted on a semiconductor chip (see JP Patent Publication (Kokai) No. 6-314314A (1994)).

### Disclosure of the Invention

The above described conventional technology does not give consideration to the mode in which the semiconductor device is assigned identification information and has the following problems.

First, the above described conventional technology assigns the identification information using a storage element and fuse group, but in this case, the storage contents of the storage element can be altered and the fuse group can also be modified, which results in a problem that the information can be easily tampered and it is difficult to maintain reliability.

Moreover, in the above described conventional technology, there is no correlation between the above described identification information based on the serial number and the above described identification information based on the user information. For this reason, unless the user specifies the serial number, it is difficult to identify the product and the semiconductor device mounted in the product, and in this way there has been a problem in identifying the presence/absence of trouble in the semiconductor device, distribution channel of the product or the user of the product, etc.

Likewise, the above described conventional technology is intended to create demanded specifications for a volume-production product based on individual demanded specifications from a plurality of users who use the products in which a semiconductor device is mounted, and therefore such specifications created would become greatest-common-denominator-like specifications or least-common-multiple-like specifications.

That is, this conventional technology determines specifications from a standpoint of semiconductor manufacturing intended for volume production of a small number of types of products and there is a problem that it is difficult to create a semiconductor device to optimum specifications for each user.

Here, instead of providing storage elements or fuse groups in all semiconductor chips, it is possible to consider a method of providing individual semiconductor chips with identification information of a layout which varies from one semiconductor chip to another, but the conventional semiconductor manufacturing method in the mainstream is a system whereby semiconductor chips are produced in volume using a mask (reticule) created by a mask manufacturing device, and therefore using layouts of different semiconductor chips as identification information requires as many masks as the semiconductor chips to be manufactured, which would drastically increase the mask creation time and cost, and such a method is actually not feasible.

It is a first object of the present invention to provide a semiconductor device provided with tamper-resistant identification information.

It is a second object of the present invention to provide a semiconductor manufacturing management system capable of managing the product from the manufacturing to the mode of use of a semiconductor device provided with physically tamper-resistant identification information.

It is a third object of the present invention to provide a semiconductor manufacturing management system capable of determining specifications of a semiconductor device provided with physically tamper-resistant identification information based on the user information.

The first object of the present invention can be attained by a semiconductor device which is a packaged semiconductor chip in which circuit patterns are formed, wherein the semiconductor chip includes two types of independent circuit patterns and identification information is expressed by at least one of these two types of independent circuit patterns.

The second object of the present invention can be attained by accessing a product mounted with a semiconductor device whose semiconductor chip includes identification information, capturing the identification information and identifying the semiconductor device based on this identification information.

The third object of the present invention can be attained by accessing a product mounted with a semiconductor device whose semiconductor chip includes identification information, capturing the identification information, identifying the semiconductor device based on this identification information, modifying demanded specification information and manufacturing a semiconductor device based on this modified demanded specification information.

### Brief Description of the Drawings

Figure 1 illustrates an embodiment of a semiconductor device according to the present invention;
Figure 2 illustrates an embodiment of design information according to the present invention;
Figure 3 illustrates another embodiment of design information of the present invention;
Figure 4 illustrates a case where physical information according to the embodiment of the present invention is expressed by combinations of vias and wiring;
Figure 5 illustrates a specific example of physical information according to the embodiment of the present invention;
Figure 6 illustrates a case where the physical information according to the embodiment of the present invention is expressed with a gate layout;
Figure 7 illustrates a case where the physical information according to the embodiment of the present invention is expressed by combinations of a resistor and capacitor;
Figure 8 illustrates an example of the case where the physical information according to the embodiment of the present invention is expressed by an aperture shape of an electron beam direct writing device when an OPC is added to a combination of vias and wiring;
Figure 9 illustrates an example of the case where the physical information according to the embodiment of the present invention is expressed by an aperture shape of an electron beam direct writing device when an OPC is added to a gate;
Figure 10 is a class diagram showing a relationship between design information, product information and user information, and usage history information according to the embodiment of the present invention;
Figure 11 is a class diagram showing a relationship between design information, user authentication information and access log according to the embodiment of the present invention;
Figure 12 is a block diagram showing an embodiment of a semiconductor manufacturing management system according to the present invention;
Figure 13 illustrates a relationship between a class and instance showing a correlation between a demanded specification, application information and mounting of a cellular phone terminal according to the embodiment of the semiconductor manufacturing management system of the present invention;
Figure 14 is a flow chart illustrating the operation of the semiconductor manufacturing management system according to the present invention;
Figure 15 is a block diagram showing an embodiment of a semiconductor manufacturing management system according to the present invention when an electron beam writing device is applied thereto;
Figure 16 illustrates demanded specifications according to the embodiment of the present invention written in UML;
Figure 17 illustrates logic information according to the embodiment of the present invention written in SystemC; and
Figure 18 is a block diagram showing an embodiment of a semiconductor manufacturing management system according to the present invention when radio access is applied thereto.

### Best Mode for Carrying Out the Invention

A semiconductor device and semiconductor manufacturing management system according to the present invention will be explained in detail according to embodiments illustrated by the attached drawings below.

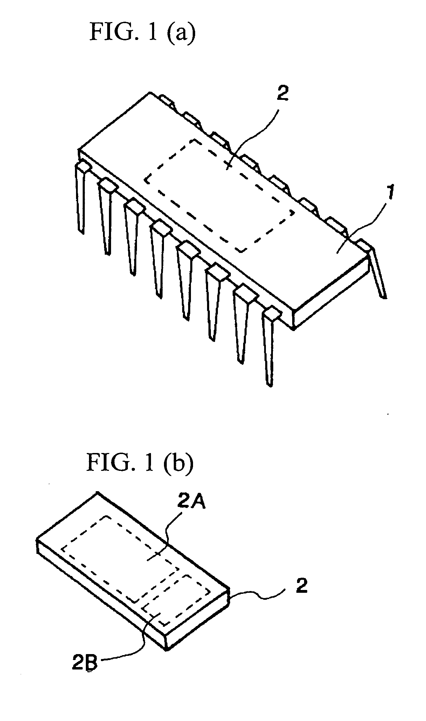

First, the semiconductor device according to the present invention will be explained first. Here, Figure 1 shows an embodiment of the semiconductor device of the present invention.

As is publicly known, a general semiconductor device consists of a packaged semiconductor chip which is the main body of an integrated circuit (IC). Thus, Figure 1(a) shows a semiconductor device 1 and a semiconductor chip 2 sealed therein and Figure 1(b) shows only the semiconductor chip 2 extracted.

In Figure 1 (b), a circuit pattern with circuit elements and wiring is formed (mounted) in the semiconductor chip 2. At this time, it goes without saying in this embodiment, too that a circuit pattern 2A necessary for the original semiconductor device is formed as shown in the figure, but in addition to that, a circuit pattern 2B, which is different from the circuit pattern 2A, is formed.

In this embodiment, the circuit pattern 2A is formed as the circuit pattern necessary for the original semiconductor device and the circuit pattern 2B is formed so as to express the aforementioned identification information. This circuit pattern 2B is expressed by physical information 20 which will be described later. Details of the physical information 20 will be explained later.

As is publicly known, except in the case of a prototype, such a semiconductor chip is normally formed by arranging a plurality of (e.g., 100) semiconductor chips on one semiconductor wafer and individually cutting (dicing) them. At this time, with regard to a circuit pattern necessary for the original semiconductor device, the same circuit pattern is formed for all semiconductor chips in each lot which is the unit of the number of products manufactured.

In this embodiment, as the one circuit pattern 2A, the same circuit pattern is formed for all semiconductor chips in each lot, while the other circuit pattern 2B is formed independently and differs from one semiconductor chip 2 to another.

As a result, in the case of this embodiment, the circuit pattern 2A is the same for all semiconductor chips in a certain lot, while the circuit pattern 2B is formed independently and differs from one semiconductor chip 2 to another, and therefore by accessing the circuit pattern 2B using a predetermined method, it is possible to read information specific to each semiconductor device.

Therefore, this embodiment allows identification information to be expressed by the circuit pattern 2B and at this time, this circuit pattern 2B is formed in the semiconductor chip itself which is sealed in the semiconductor device, and therefore after the product is manufactured, it is not possible to tamper it unless the sealing is destroyed and even in case of tampering, the tampering can be recognized immediately.

Therefore, this embodiment eliminates the possibility of tampering and can provide a semiconductor device furnished with highly reliable identification information.

Next, the semiconductor manufacturing management system according to the present invention will be explained.

Here, the semiconductor manufacturing management system is premised on the above described semiconductor device according to the present invention and intended to facilitate management of the product from the manufacturing to tracking, etc., of the mode of use of the semiconductor device.

First, various types of information according to an embodiment of the present invention will be explained.

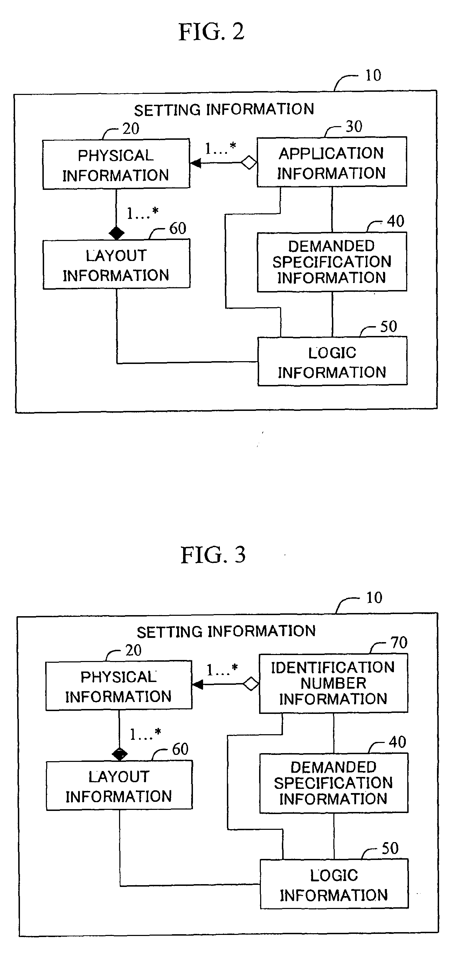

Here, Figure 2 expresses design information 10 according to an embodiment of the present invention including a correlation among various pieces of information in UML (Unified Modeling Language).

This design information 10 includes demanded specification information 40 showing specifications demanded for the semiconductor device, application information 30 showing a pattern specific to the semiconductor, that is, how the above described circuit pattern 2B is used, physical information 20 showing the shapes of gate, transistor, via, contact, wiring conductor strip making up the above described circuit pattern 2B, logic information 50 derived from the demanded specification information 40 and layout information 60 generated from this logic information 50.

Here, the above described logic information 50 is expressed in a logic descriptive language such as logic circuit, netlist, Verilog and programming language such as SystemC and descriptive language such as UML.

Furthermore, the layout information 60 may be CAD data such as GDSII or may be binary format data specific to the device. This layout information 60 includes at least one piece of physical information 20. Furthermore, the application information 30 also has a relationship with at least one piece of physical information 20.

At this time, the demanded specification information 40, logic information 50, application information 30, layout information 60 and physical information 20 can be expressed in UML as described above and such a data correlation can be realized easily from an object-oriented database.

In this way, it is possible to identify physical information corresponding to application information, which can be hardly realized by the conventional semiconductor manufacturing management system. Thus, it is also possible to decide whether a product is an imitation or not by only investigating the physical information corresponding to the application information whose structure becomes a problem without the need to investigate layout information, etc., of the entire semiconductor.

Next, Figure 3 shows an embodiment in a case where the application information means an identification number and the physical information shows the correlation of a semiconductor indicating 16-bit hexadecimal data in UML, and in this case, the demanded specification information 40 of the semiconductor of the design information 10 is provided with identification number information 70 indicating that the specific pattern corresponds to the identification information.

The aspect of this embodiment including the physical information 20, logic information 50 and the layout information 60 generated from the logic information 50 is the same as the embodiment in Figure 2 and at this time, the identification number information 70 has a relationship with at least one piece of physical information 20 and the layout information 60 has at least one piece of physical information 20.

Under such data management, individual identification numbers and individual pieces of physical information can have a one-to-one correspondence, making it possible to manage the design information and semiconductor which is the final product.

Here, it is also possible to use identification information such as EPC (Electronic Product Code) and ISBN (International Standard Book Numbering) as these pieces of information.

Next, the method of expressing identification information by the physical information 20 according to this embodiment will be explained. Here, this physical information 20 is used to express the circuit pattern 2B as described above.

First, as is publicly known, a circuit pattern formed in a semiconductor is generally constructed of circuit elements such as gate and transistor and wiring part such as via, contact and wiring conductor strip.

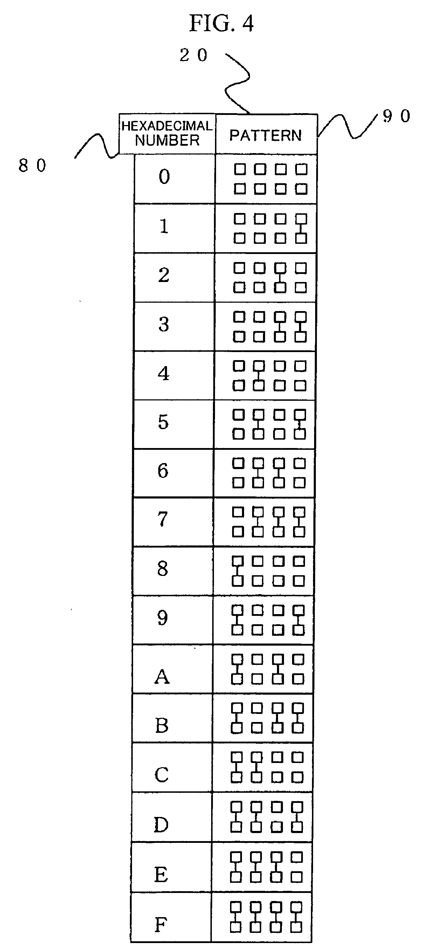

First, Figure 4 is an embodiment in a case where the physical information 20 is realized by combinations of vias and wiring conductor strips and this expresses the physical information 20 using a numerical value representing a hexadecimal number, that is, hexadecimal value 80 and a pattern 90 corresponding to the numerical value 80 in order to establish a correlation with the identification number information 70.

Therefore, it is possible to obtain a layout 100 corresponding to the identification number information 70 by associating each digit in this Figure 4 with the numerical value 80 of the physical information 20 in Figure 4, selecting the patterns 90 corresponding to the respective hexadecimal numbers and arranging the patterns.

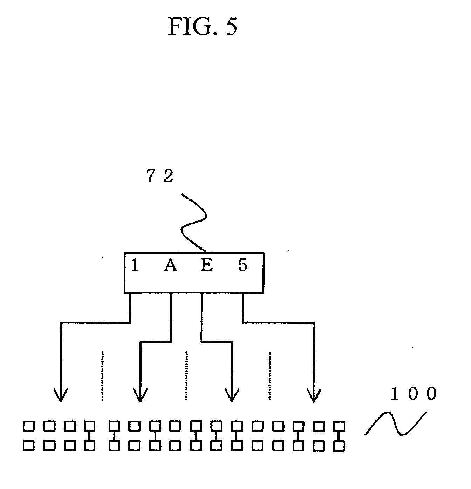

Here, an example of the identification number information 70 expressed by this physical information 20 is shown in Figure 5. This shows a case where an identification number 72 which is an instance of the identification number information 70 is 0x1AE5 . Here, "0x" is a prefix indicating that this numerical value is hexadecimal.

Here, since such a circuit pattern is conventionally formed using a mask, it has been difficult to build in a pattern which differs from one semiconductor chip to another, but this can be currently easily realized by directly drawing a pattern on a photomask using electron beams, that is, using a mask-less technique by means of an "electron lithography."

Therefore, according to the embodiments in these Figures 4 and 5, it is possible to create physical information from identification numbers which differ from one another, manufacture a semiconductor having a layout made up of vias and wiring which differ from one another and make physical replication more difficult.

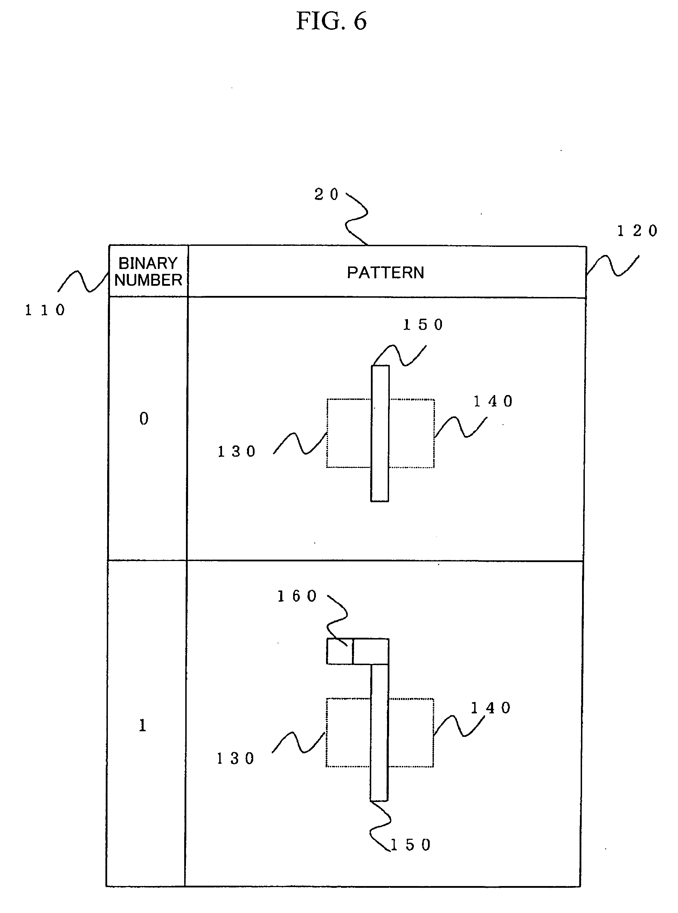

Next, Figure 6 is an embodiment in a case where the physical information 20 is expressed by a ROM (read-only memory) cell corresponding to 1 bit as a logic circuit and the cell at this time is formed as a transistor (FET) having a source 130, a drain 140 and a gate 150.

In this case, a cell corresponding to "0" of a binary numerical value 110 has a pattern whose gate 150 is floating and a cell corresponding to "1" of the binary numerical value 110 has a pattern to be connected to a via 160 with the gate 150 connected to a power supply Vcc, etc., constituting a pattern in which the source 130 becomes electrically continuous to the drain 140.

Therefore, according to the embodiment in Figure 6, it is possible to provide a logic circuit which stores an individual bit string as an individual pattern 1B of each semiconductor chip by arranging the ROM cells in a desired bit string.

Conventionally, since such a ROM is generally mounted as a mask ROM in which a bit string and binary values are fixed, it has been difficult to build in the ROM with a bit string and binary value which differ from one semiconductor to another, but as described above, such a ROM can be easily implemented using a mask-less technique using an electron lithography.

Furthermore, by storing a program binary code in a logic circuit such as this ROM, it is also possible to mount a program which varies from one semiconductor chip to another and in this case, it is also possible to embed identification information in the semiconductor chip as static data in the program such as PML (Physical Mark-up Language).

Moreover, when individual semiconductor chips are made to have different logic circuits, there is also an advantage that physical replication of a semiconductor chip itself becomes difficult. Such a logic circuit is not limited to the above described ROM and can also be constructed of a logic circuit such as flip flop.

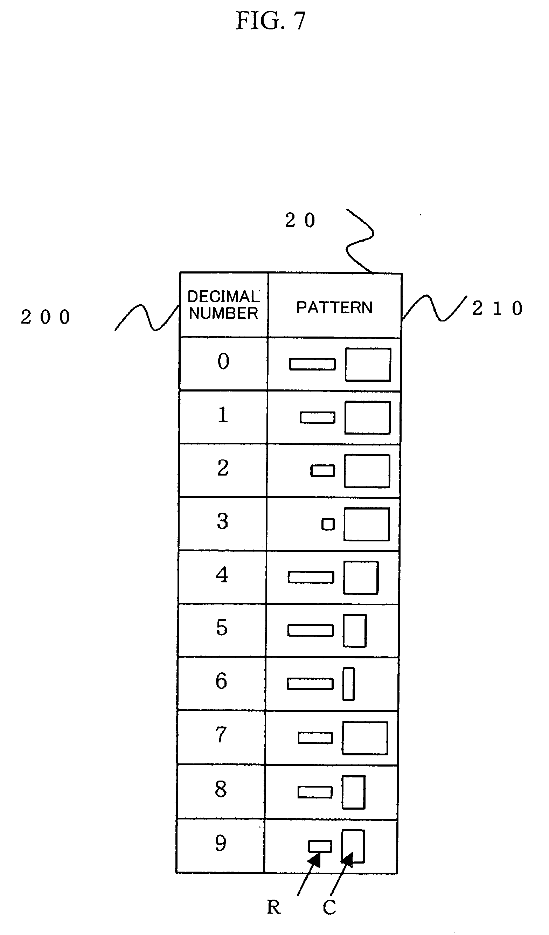

Furthermore, Figure 7 is an embodiment in a case where the circuit pattern 2B is expressed by an analog circuit and the physical information 20 is expressed by a time constant circuit of R (resistor value of a resistor element) and C (capacitance value by a capacitor element). The analog circuit in this case includes a circuit pattern 210 which is a combination of R and C, and assigned a time constant by R and C of the pattern 210 so as to correspond to each decimal value 200.

By so doing, it is possible to realize an analog circuit which generates different time constants according to a combination of a resistor element (R) and capacitor (C) and express arbitrary identification information by associating this time constant with identification information.

Here, the analog circuit is not limited to the RC time constant circuit shown in this embodiment, but it can also be an analog circuit such as an RF circuit varying in the frequency and modulation scheme.

Therefore, by combining the above described embodiments, it is possible to manufacture a semiconductor device incorporating a semiconductor chip having unique identification information, carrying out program operations by a unique logic circuit, that is, carrying out unique operations and operating at a unique frequency and according to a unique modulation scheme.

For example, suppose an IC tag number and serial number of an IC card are used as identification information. Then, it is possible not only to assign identification information whose number varies from one IC tag and IC card to another using physically different patterns but also to incorporate encryption and decryption processes of an authentication number for each IC tag and IC card as programs operating according to different encryption and decryption algorithms.

Furthermore, since communications at different frequencies and according to different modulation schemes are possible, it is possible to improve reliability of a product such as a bill with a built-in IC tag or IC card and improve the level of difficulty in replication.

Here, in implementing the present invention, it is preferable to directly draw a pattern in a photoresist layer by means of electron beams, that is, use a mask-less technique by means of an electron lithography as described above. Here, the device used for this technique is called an "electron beam direct writing device."

When patterns are relatively simple, this electron beam direct writing device can form all patterns almost simultaneously by single irradiation of electron beams using an aperture of a template pattern (which may also be referred to as "self-projection aperture" or "block exposure aperture").

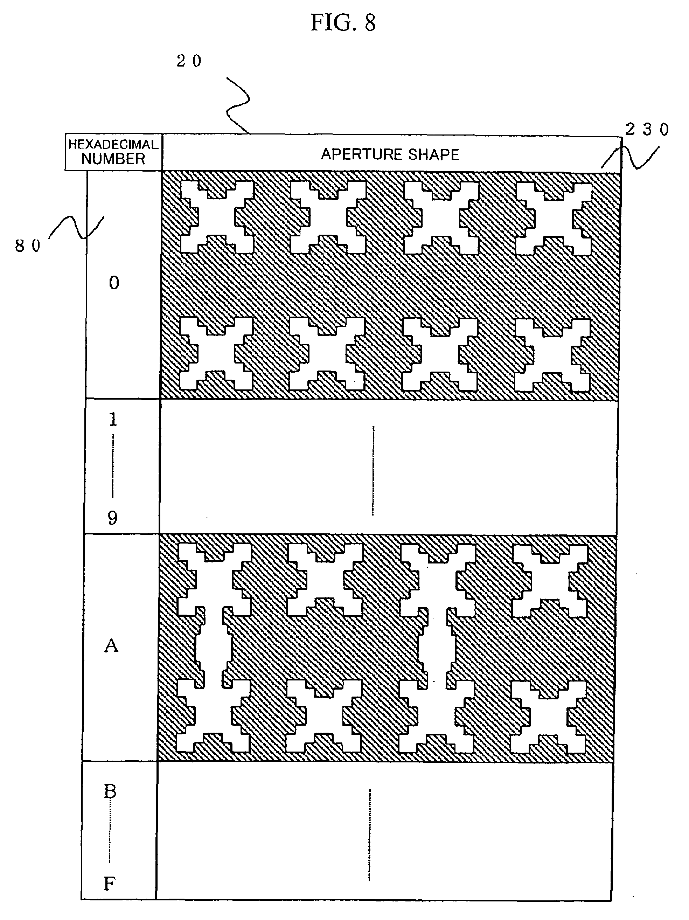

Next, an embodiment in a case where apertures of a template pattern of this electron beam direct writing device are used as the physical information 20 will be explained using Figure 8.

Here, the embodiment in this Figure 8 uses the pattern of the above described apertures instead of the vias in the pattern 90 in Figure 4, expresses a hexadecimal numerical value 80 by an aperture pattern and shows only the case where the numerical value 80 corresponds to hexadecimal numerical values 1 and A.

According to this embodiment, when, for example, the physical information 20 is expressed by a hexadecimal numerical value, it is possible to form the circuit pattern 2B corresponding to the physical information 20 by preparing 16 types of templates from hexadecimal numerical values 0 to F, sequentially selecting as many templates as digits of the physical information 20, one template at a time, sequentially irradiating electron beams and thereby obtain an exact circuit pattern easily in a short time.

Here, unlike the shapes of the vias in the physical information 20 in Figure 4, quasi-X-shaped patterns 230 are shown in this Figure 8 and this is intended for correction of clone defocusing, which becomes necessary as the patterns become finer.

Using these quasi-X-shaped patterns 230, the shapes of the patterns actually formed in the semiconductor chip become (quasi-square) shapes necessary for the physical information 20. Therefore, when no clone defocusing correction is performed, the shapes of the apertures are generally the same as the shape of the physical information 20.

Here, the method of creating a normal aperture must follow a procedure of extracting graphics having a high number of iterations and creating apertures based on this graphics after all layouts are created, which requires an extremely long time and causes a problem which is not negligible in terms of practicality.

However, this embodiment only requires creation of apertures from the application information 30 in Figure 2 or identification number information 70 in Figure 3, and can thereby create the apertures easily in a short time.

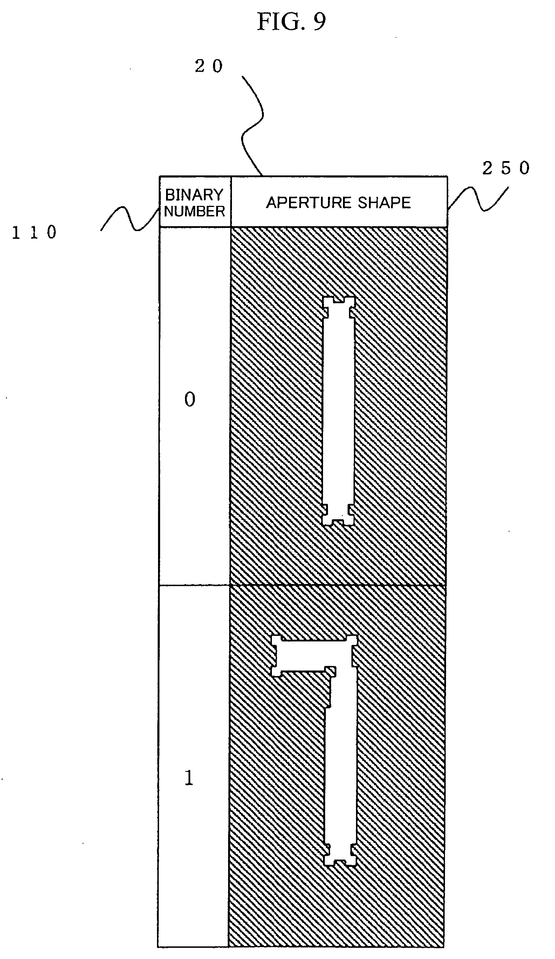

Next, Figure 9 likewise shows an embodiment in a case where a template pattern of an electron beam direct writing device is used. At this time, the patterns of the above described apertures are used as the gate 150 and via 160 in the patterns 120 of Figure 6, the hexadecimal numerical values 120 are expressed by the aperture patterns and at this time, only the case where the numerical values 120 are the hexadecimal numerical values 1 and 2 as in the case of Figure 6.

This embodiment in Figure 9 also shows that the shapes of the apertures are different from the physical information 20 in Figure 6 for the purpose of clone defocusing correction accompanying a process of miniaturization.

Thus, this embodiment, which forms circuit patterns on the semiconductor chip 1 using an electron beam direct writing device and using apertures, can draw complicated graphics without any masks all at once, and can thereby shorten the drawing time of different circuit patterns 2B.

Next, the management of the product from the manufacturing to tracking of a mode of use of a semiconductor device in a semiconductor manufacturing management system according to the present invention will be explained. First, this embodiment associates semiconductor physical information, application information, demanded specification information, logic design information and layout information of the entire semiconductor with one another and stores this as design information.

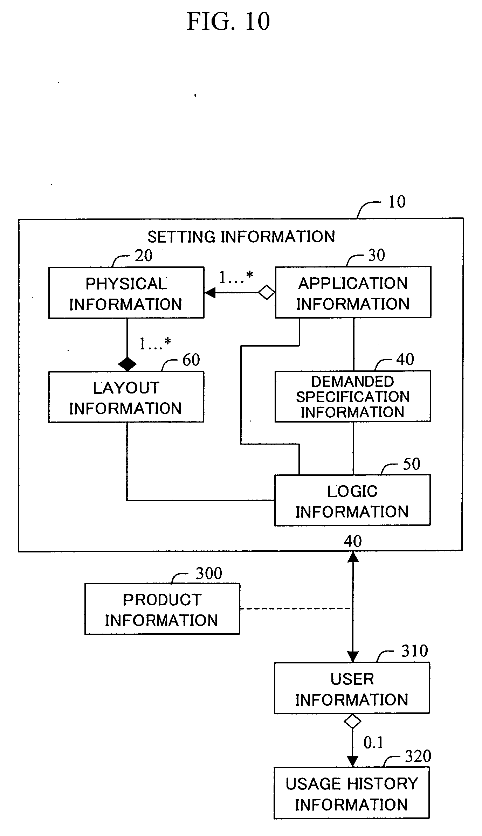

Here, Figure 10 expresses a correlation between the design information 10, product information 300, user information 310 of the product and usage history information 320 based on the mode of use by each user in UML according to an embodiment of the present invention.

At this time, the design information 10 is as has already been explained in Figure 2. Here, the product information 300 corresponds to, for example, a manufacturing number of a semiconductor device and stores the correlation between the design information 10 and user information 310.

Next, the user information 310 corresponds to a serial number of an individual semiconductor device and stores or does not store the usage history information 320. Here, the usage history information 320 corresponds to information expressing contents of a claim if any, about the presence/absence of malfunction, for example.

Associating the design information 10, product information 300, user information 310 and usage history information 320 with one another facilitates management of a product mounted with a semiconductor device having a pattern which differs from one device to another.

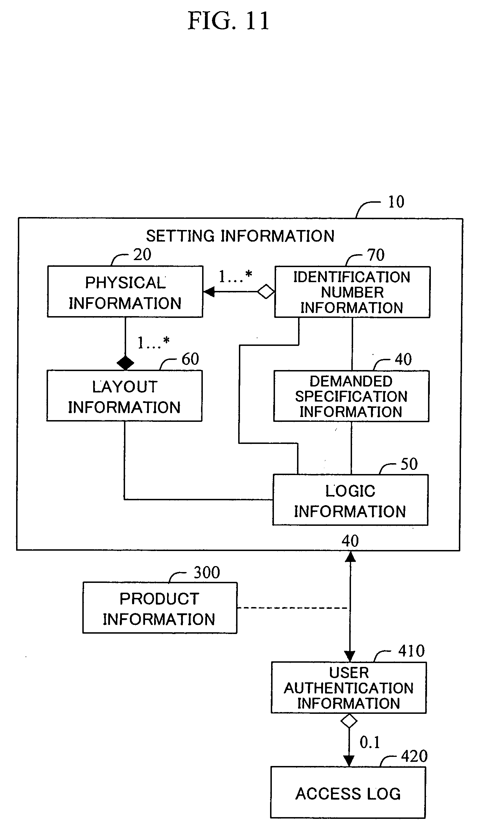

Next, Figure 11 expresses a correlation between the design information 10, product information 300 and respective pieces of information according to another embodiment of the present invention in UML. Here, the design information 10 includes the identification number information 70 explained in Figure 3 and expresses a correlation of user authentication information 410 of the product and an access log 420 of each user with the product information 300 in UML.

Therefore, the design information 10 is as has already been explained in Figure 3. Here, the product information 300 corresponds to, for example, a telephone number assigned to a cellular phone terminal in a WEB system for the cellular phone terminal and stores a correlation between the design information 10 and user authentication information 410.

Then, in this case, the user authentication information 410 corresponds to a user name and password assigned to each user of an individual cellular phone terminal and stores or does not store the access log 420. Here, the access log 420 corresponds to information on the time during which the user accesses the WEB through the cellular phone terminal and pages accessed.

Associating the design information 10, product information 300, user authentication information 410 and access log 320 with one another in this way facilitates management of products mounted with semiconductor devices having different patterns, can track preferences of each user, tailor the demanded specification information 40 according to each user and create new demanded specification information 40.

Then, an embodiment of a semiconductor manufacturing management system according to the present invention which associates the above described physical information of a semiconductor, application information, demanded specification information, logic design information and layout information of the entire semiconductor with one another and stores it as design information will be explained.

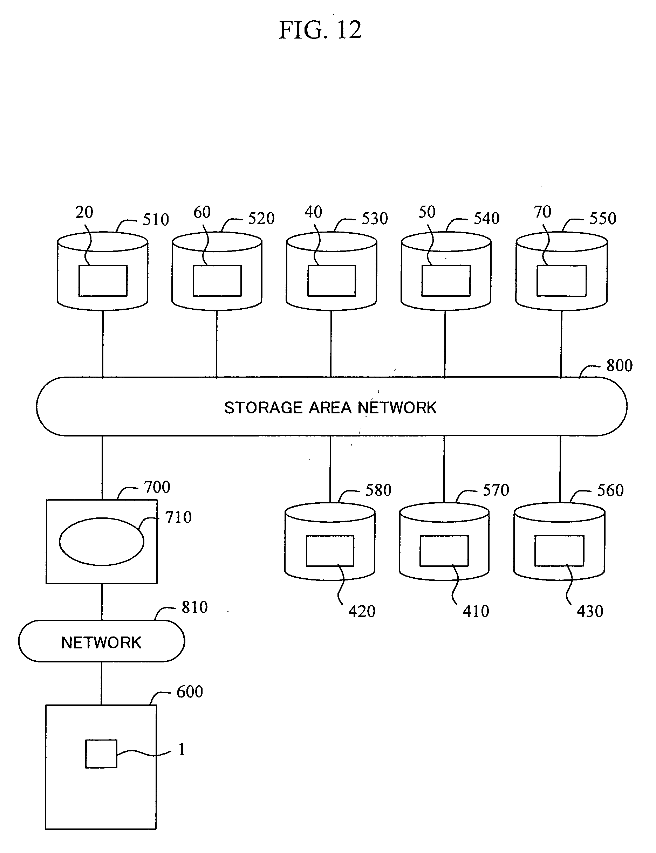

First, Figure 12 shows an embodiment according to the present invention applied to a case where the product mounted with the semiconductor device 1 according to the present invention (Figure 1) is a portable terminal such as cellular phone and a server accesses this cellular phone terminal 600 over a network. In this figure, reference numeral 700 denotes a computer of a semiconductor manufacturing management system, which accesses the cellular phone terminal 600 over the network 810.

For this purpose, the computer 700 is provided with storage devices 510, 520, 530, 540, 550, 560, 570, 580 and connected to them through a storage area network 800.

The storage device 510 stores the physical information 20, the storage device 520 stores the layout information 60, the storage device 530 stores the demanded specification information 40, the storage device 540 stores the logic information 50 and the storage device 550 stores the identification number information 70.

Furthermore, the storage device 560 stores the product information 300, the storage device 570 stores the user authentication information 410 and the storage device 580 stores the access log 420.

At this time, a WEB server program 710 is operating on the computer 700 and allows each server to arbitrarily access the cellular phone terminal 600 mounted with the semiconductor device 1 whose semiconductor chip 2 is provided with a circuit pattern 2B which varies from one chip to another through the network 810.

Then, the WEB server program 710 references the user authentication information 410 stored in the storage device 570, carries out authentication with respect to the access to the cellular phone terminal 600 and stores information on the access to the cellular phone terminal 600 as the access log 420 in the storage device 580.

Therefore, this system structure makes it possible to track each product mounted with the semiconductor device 1 by reading the access log 420 from the storage device 580 and also collect data as to how the user mounts the semiconductor device 1 in the product and how the user uses the product.

Here, in the embodiment in Figure 12, the storage device 570 stores the user authentication information 410 as the user information of the device, but if this is replaced by charts information of a patient recorded at a medical institution and the cellular phone terminal 600 as the product is replaced by a medical check chip manufactured for each patient, it is possible to provide a medical check chip best suited to each patient.

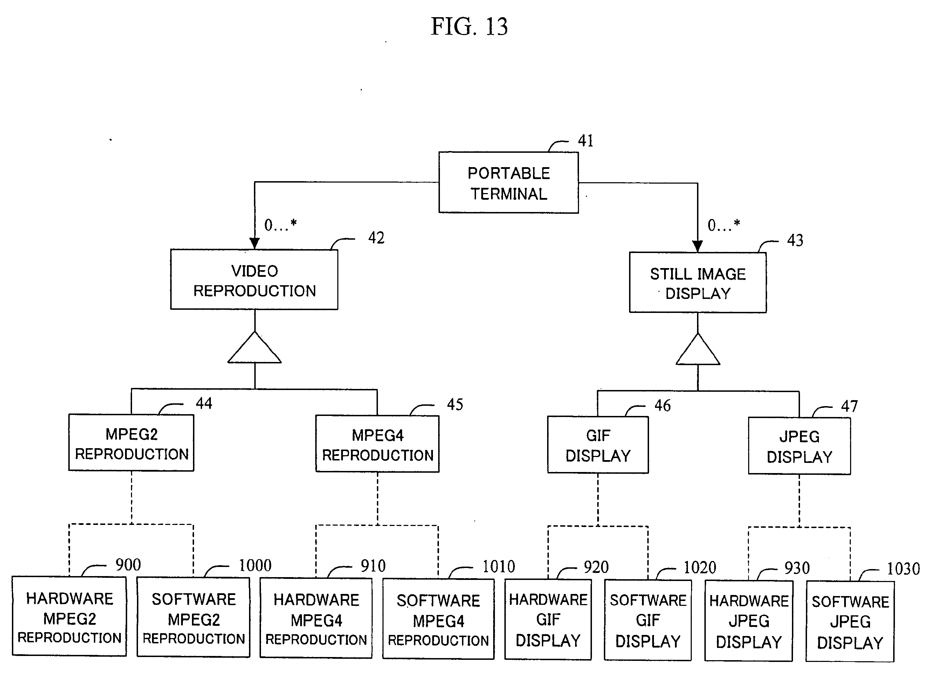

Next, Figure 13 will explain a case where an example of the demanded specification information 40 in the embodiment in this Figure 12 is expressed in UML. Here, the cellular phone terminal 41 shown in this Figure 13 corresponds to the cellular phone terminal 600 in Figure 12.

This cellular phone terminal 41 supports no video reproduction 42 or supports reproduction of at least one video image, supports no still image display 43 or supports display of at least one still image.

At this time, as a continuation of the video reproduction 42, there are two types of data; MPEG2 format video data reproduction 44 and MPEG4 format video data reproduction 45.

The MPEG2 format video data reproduction 44 includes MPEG2 reproduction mounting 900 by hardware and MPEG2 reproduction mounting 1000 by software, and the MPEG4 format video data reproduction 45 includes MPEG4 reproduction mounting 910 by hardware and the MPEG4 reproduction mounting 1010 by software.

On the other hand, as a continuation of the still image display 43, there are two types of display; GIF format still image data display 46 and JPEG format still image data display 47.

First, the GIF format still image data display 46 includes GIF display mounting 920 by hardware and GIF display mounting 1020 by software and the JPEG format still image data display 47 includes JPEG display mounting 930 by hardware and JPEG display mounting 1030 by software.

Therefore, according to the embodiment which applies the demanded specification information 40 in this Figure 13, it is possible to select and mount the video reproduction 42 and still image display 43 under a free combination from hardware or software.

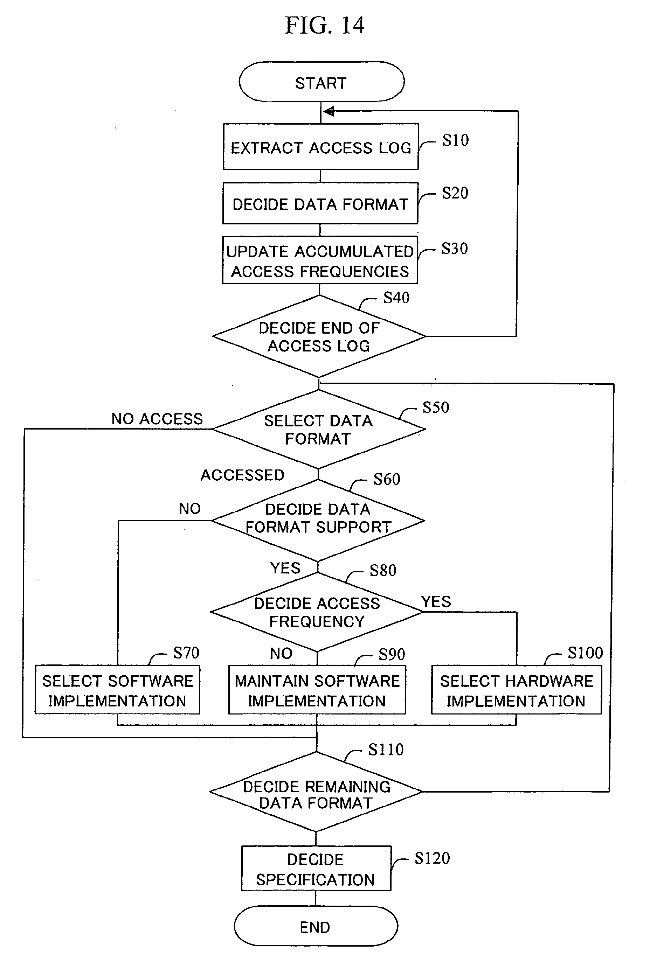

Next, a process of creating the demanded specification information 40 suitable for each user based on the access log 420 which is information on the access to the cellular phone terminal 600 (41) by applying the demanded specification information 40 in Figure 13 to the system in Figure 12 will be explained using the flow chart in Figure 14.

Once the process is started according to the flow chart in Figure 14, information on each access is extracted (S10) from the access log 420 first and then the accessed data format is decided from this information for each access (S20).

Here, the data format at this time is generally decided based on the identifier of the file corresponding to the accessed data.

In the case of a video image, for example, a file name for storing the MPEG2 format data is generally assigned an identifier such as 'mpg' and 'mp2' and in the case of a still image, a file name for storing the JPEG format data is assigned an identifier such as 'jpg' and it is possible to decide the data format through an lexical analysis from access information.

Next, the access frequency is updated for each data format (S30) and the above described steps are repeated until the end of the access log is reached (S40). Then, the access frequencies are accumulated for each data format by executing the above described steps.

Next, the presence/absence of access is checked for each data format and the process is branched to a process of selecting a mounting mode (S50). When access occurs in S50, it is decided whether the selected data format is supported or not (S60), and if the data format is not supported here, the software implementation corresponding to the data format is newly selected (S70).

On the other hand, if the data format is already supported, the access frequency is decided (S80). When the frequency does not exceed a predetermined value, the software implementation corresponding to the data format is maintained (S90) and when the frequency exceeds the predetermined value, the mounting is changed to the hardware implementation corresponding to the data format (S100).

Then, the above described steps are repeated for all data formats (S110), the processing result is decided as a new specification (S120).

Therefore, this embodiment analyzes the access log which continues to be stored at an arbitrary time point and takes a step of reflecting the access log in a new specification, but the system structure in Figure 12 also allows a sequence for realizing the update S30 of access frequency for each access to be adopted.

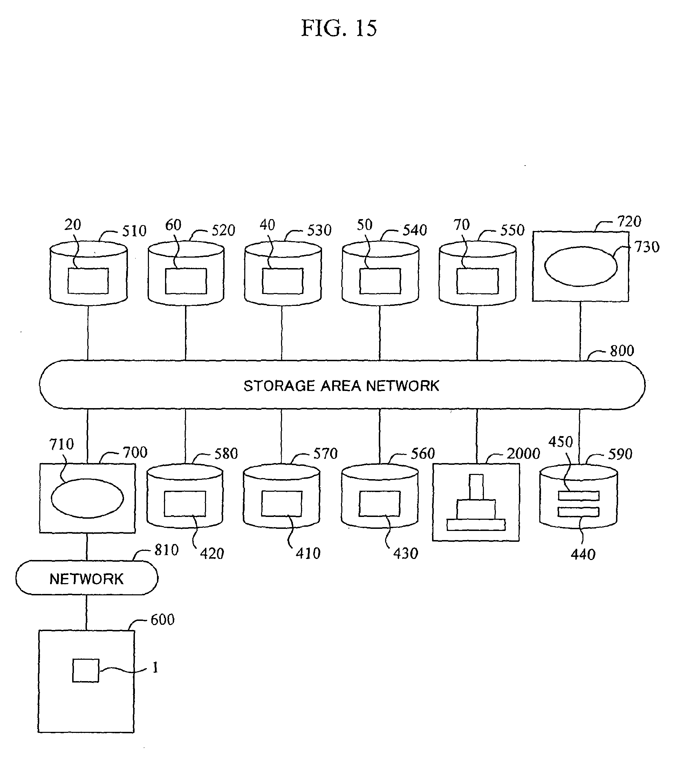

Next, an embodiment of a system structure which allows different semiconductors corresponding to a new specification created through the process in Figure 14 to be manufactured without any mask will be explained using Figure 15.

Here, the embodiment in Figure 15 corresponds to the embodiment in Figure 12 with a storage device 590, a computer 720 and an electron beam direct writing device 2000 added and the rest of the structure is the same as the structure of the embodiment in Figure 12.

First, the storage device 590 has the function of storing drawing information 440 of a data format interpretable by the electron beam direct writing device 2000 and information 450 on apertures of the electron beam direct writing device 2000.

Next, the computer 720 is mounted with an EDA program 730 and has the function of generating drawing information 440 using this program based on information stored in each storage device through a storage area network 800 and storing the drawing information 440 in the storage device 590.

In this way, the storage device 590, computer 720 and electron beam direct writing device 2000 are also connected to the storage area network 800 and can access the storage devices 510, 520, 530, 540, 550, 560, 570, 580 and computer 700.

Here, a WEB server program 710 is also operating on the computer 700 and can arbitrarily access a cellular phone terminal 600 mounted with a semiconductor device 1 whose semiconductor chip 2 is provided with a circuit pattern 2B which varies from one chip to another through the network 810.

Then, the WEB server program 710 references user authentication information 410 stored in the storage device 570, carries out authentication with respect to the access to the cellular phone terminal 600 and stores the information on the access to the cellular phone terminal 600 in the storage device 580 as an access log 420.

Therefore, this system structure makes it possible to track each product mounted with the semiconductor device 1 by reading the access log 420 from the storage device 580 and further collect data as to how the user mounts the semiconductor device 1 in the product and uses the product.

Then, as described above, the EDA program 730 operates on the computer 720 at this time, generates drawing information 440 based on the information stored in each storage device through the storage area network 800, which facilitates the manufacturing of the semiconductor chip 2 by the electron beam direct writing device 2000.

Therefore, according to this embodiment, it is possible to eliminate an enormous amount of mask data in semiconductor manufacturing premised on a mask, reduce the manufacturing cost associated with creation of the mask, reduce the cost and it is necessary to manage only the same layout information as physical information which varies from one device to another, making it possible to reduce the amount of data to be managed.

Furthermore, since the product information, user information and access log which indicates the mode of use by the user are managed, it is possible to track and manage the individual semiconductor devices and create a demanded specification best suited to each user based on the mode of use by the user.

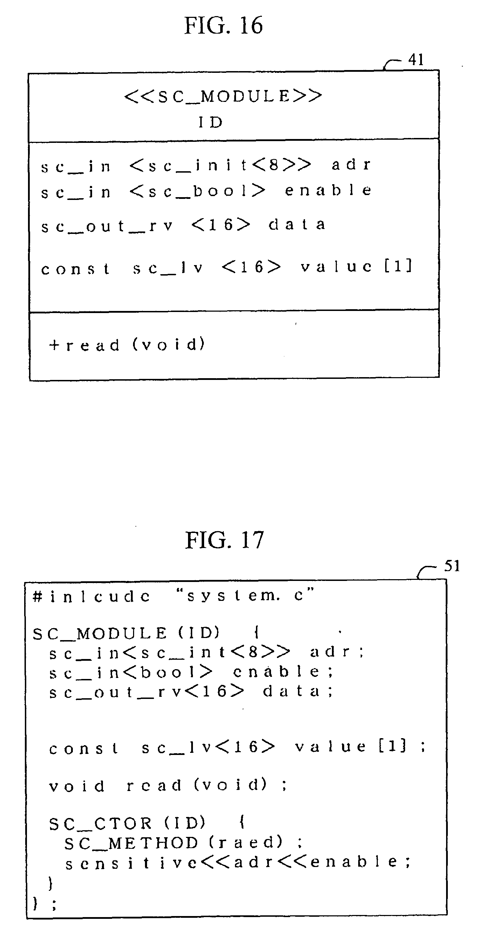

Here, Figure 16 shows, as an example of the demanded specification information 40 according to the embodiment of the present invention, a case where 16-bit hexadecimal data of the identification number (ID) shown in Figure 3 is expressed in UML. This demanded specification information 40 may be expressed by a use case diagram, etc., but it may also be part of the logic information 50 at this time.

Figure 17 shows an example of a case where the logic information 50 corresponding to the UML in Figure 16 is a source code of SystemC. The logic information 50 is expressed in SystemC in this example, but the embodiment of the present invention is not limited to this language and a logic descriptive language such as VHDL may also be used.

Examples of a product mounted with the semiconductor device 1 of the present invention are a non-contact IC card called "RF tag" and non-contact commutation ticket, and access is made by radio (RF) in this case.

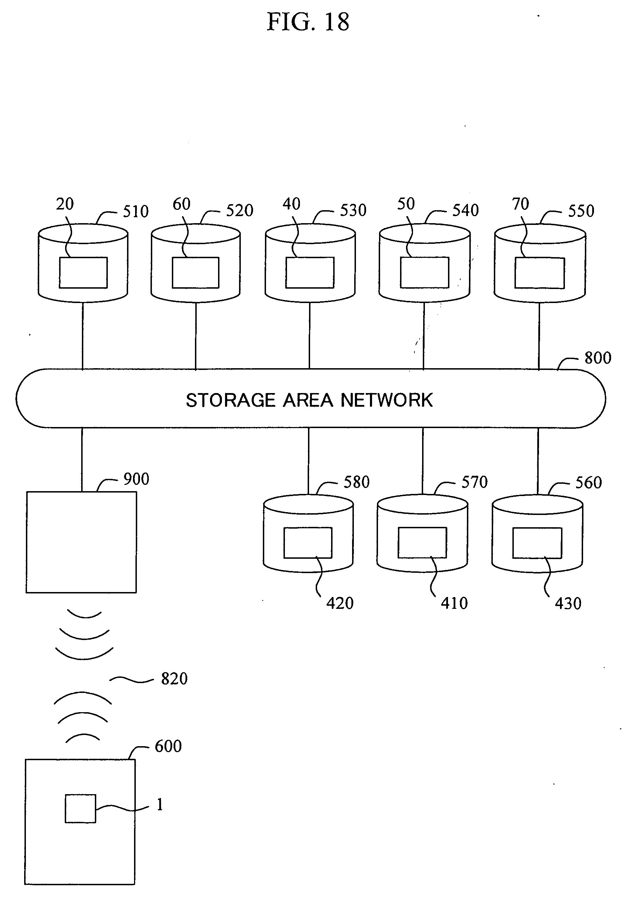

Next, an embodiment of the present invention which allows access by radio will be explained using Figure 18. The product mounted with the semiconductor device 1 according to the present invention is an RF tag 610 and an RF tag reader 900 is used as the computer on the system side, and the system is constructed so as to enable access by a radio transmission system 820 instead of the network 810 in Figure 12 or Figure 13 and the rest of the structure and operation are the same as those in Figure 12 and Figure 15.

Here, the RF tag reader 900 is transmitting, for example, microwave all the time or whenever necessary. Thus, when the RF tag 610 mounted with the semiconductor device 1 comes closer to this RF tag reader 900, the RF tag 610 reacts the received microwave, starts to operate and enables access through the radio transmission system 820.

### Industrial Applicability

The present invention can provide a highly reliable semiconductor device which makes tampering and replication difficult.

Furthermore, the present invention can track a product mounted with a semiconductor device, and can thereby facilitate management from the manufacturing to the mode of use of the semiconductor device.

Furthermore, the present invention can determine the aperture shapes of parts related to application information from the design stage, and can thereby improve throughput in manufacturing of the semiconductor device.

Likewise, the present invention can manage demanded specification information, design information of a semiconductor with some parts having specific patterns and other parts having a common pattern, layout information, user information of the product mounted with the semiconductor and information on the mode of use of the product by the user, and can thereby manage and track the product mounted with the semiconductor.

Likewise, the present invention can manage demanded specification information, design information of a semiconductor with some parts having specific patterns and other parts having a common pattern, layout information, user information of the product mounted with the semiconductor and information on the mode of use of the product by the user, and can thereby generate specifications best suited to each user according to the mode of use, feed them back to the demanded specification information and thereby manufacture a semiconductor device specific to and best suited to each user, which differs from one device to another.

## Claims

1. A semiconductor device comprising a packaged semiconductor chip in which circuit patterns are formed,
wherein at least two types of independent circuit patterns are formed in said semiconductor chip, and
identification information is expressed by at least one of said two types of independent circuit patterns.

2. The semiconductor device according to claim 1, wherein circuit patterns of at least one of said types are formed by a direct drawing technology.

3. The semiconductor device according to claim 1, wherein said identification information is expressed by a combination of patterns formed in different steps in a semiconductor process.

4. The semiconductor device according to claim 3, wherein circuit patterns of at least one of said types express said identification information by a combination of vias and wiring.

5. The semiconductor device according to claim 1, wherein said identification information is expressed by an output of a logic circuit.

6. The semiconductor device according to claim 1, wherein said circuit is a logic circuit that means a program which outputs said identification information.

7. The semiconductor device according to claim 1, wherein said identification information is expressed by an output of an analog circuit.

8. A semiconductor manufacturing management system which accesses a product mounted with a semiconductor device whose semiconductor chip has identification information to collect said identification information, and
identifies said semiconductor device based on the identification information.

9. The semiconductor manufacturing management system according to claim 8, wherein the semiconductor device mounted in said product is tracked and a situation of use thereof is grasped from an identification result of said semiconductor device based on said identification information.

10. The semiconductor manufacturing management system according to claim 8, wherein said access is made through a network.

11. The semiconductor manufacturing management system according to claim 8, wherein said access is made through a radio transmission system.

12. A semiconductor manufacturing management system which accesses a product mounted with a semiconductor device whose semiconductor chip has identification information to collect said identification information,
identifies said semiconductor device based on the identification information and modifies demanded specification information, and
manufactures said semiconductor device based on the modified demanded specification information.

13. The semiconductor manufacturing management system according to claim 12, wherein said access is made through a network.

14. The semiconductor manufacturing management system according to claim 12, wherein said access is made through a radio transmission system.

15. The semiconductor manufacturing management system according to claim 12, wherein said semiconductor device is manufactured using a mask-less technique.

16. The semiconductor manufacturing management system according to claim 12, wherein said semiconductor device is manufactured using a direct writing device.

17. The semiconductor manufacturing management system according to claim 12, wherein said semiconductor device is manufactured using a mask-less technique using aperture patterns of a direct writing device.
